# NEUE EUROPÄISCHE PATENTSCHRIFT

(11) **EP 0 974 192 B2**
(45) Veröffentlichungstag und Bekanntmachung des Hinweises auf die Entscheidung über den Einspruch: **17.01.2007**
(45) Hinweis auf die Patenterteilung: 19.12.2001
(21) Anmeldenummer: 98912221.3
(22) Anmeldetag: 14.02.1998
(51) Int. Cl.: H03J 1/00

(54) **Rundfunkempfänger mit Erstellung und Speicherung von benutzerspezifischen Bedienungsmenüs**
Radioreceiver with creating and storing user-specific operating menus
Récepteur de radiodiffusion avec établissement et mémorisation de menus d'utilisation spécifiques pour un utilisateur

(30) Priorität: 11.04.1997 DE 19715052
(43) Veröffentlichungstag der Anmeldung: 26.01.2000
(73) Patentinhaber: ROBERT BOSCH GMBH, 70442 Stuttgart (DE)
(72) Erfinder: GERLINGS, Karl-Heinz, D-38259 Salzgitter (DE)
(86) Internationale Anmeldenummer: PCT/DE1998/000424
(87) Internationale Veröffentlichungsnummer: WO 1998/047228

(56) Entgegenhaltungen:
- EP-A- 0 359 476
- EP-A2- 0 737 006
- DE-A- 4 006 427
- DE-A- 4 329 552
- DE-C2- 4 201 031
- DE-T2- 69 111 727
- WERNER HENZE: "Sendertabelle im RAM" FUNKSCHAU., Nr. 10, Mai 1984, MUNCHEN DE, Seiten 46-49, XP002068019
- CHIPTOOL 9/1989, Deckblatt und Seiten 74-79

## Beschreibung

### Stand der Technik

Die Erfindung geht von einem Rundfunkempfänger nach der Gattung des unabhängigen Anspruchs 1 aus.

Verfahren zur Erstellung und Speicherung von benutzerspezifischen Bedienmenüs sind für die Gestaltung von Bedienoberflächen bei Computern bereits bekannt.

Aus dem Blaupunkt-Katalog "Programm'96/'97, Sound und Fahrvergnügen pur. Mobile Telekommunikation von Blaupunkt." ist bereits das Autoradio "New York RDM 127" bekannt, bei dem eine Anzeigevorrichtung und seitlich an der Anzeigevorrichtung angebrachte Auswahltasten vorgesehen sind, die einzelnen an der Anzeigevorrichtung darstellbaren Bedienfunktionen zugeordnet sind. Die Bedienfunktionen sind dabei menügesteuert an der Anzeigevorrichtung darstellbar, wobei die Zuordnung der Bedienfunktionen zu den Auswahltasten vom Benutzer nicht beeinflußbar ist.

### Vorteile der Erfindung

Der erfindungsgemäße Rundfunkempfänger mit den Merkmalen des Anspruchs 1 hat den Vorteil, daß er die Erstellung und Speicherung benutzerspezifischer Bedienmenüs ermöglicht. Auf diese Weise wird der Bedienkomfort für den Benutzer erhöht, da er die Anordnung von Bedienfunktionen in Bedienmenüs seinen Anforderungen und Bedürfnissen selbst anpassen kann. So kann er beispielsweise ein Bedienmenü mit Bedienfunktionen erstellen, die von ihm besonders häufig verwendet werden. Die Bedienung wird mittels eines Drehschalters zur Adressierung eines vorgegebenen Speicherbereichs erleichtert.

Durch die in den abhängigen Ansprüchen aufgeführten Maßnahmen sind vorteilhafte Weiterbildungen und Verbesserungen des im Anspruch 1 angegebenen Rundfunkempfängers möglich.

Vorteilhaft ist es, daß eine Menütaste vorgesehen ist, durch deren Betätigung der Inhalt des mindestens einen vorgegebenen Speicherbereiches an der Anzeigevorrichtung darstellbar ist, wobei jeder Auswahltaste die Bedienfunktion zugeordnet ist, die auf dem durch diese Auswahltaste adressierten Speicherplatz gespeichert ist, und wobei durch Betätigung einer Auswahltaste die ihr zugeordnete Bedienfunktion aktiviert wird. Auf diese Weise steht das benutzerspezifische Bedienmenü mit den individuell angeordneten Bedienfunktionen für die Bedienung des Rundfunkempfängers genauso zur Verfügung wie jedes andere voreingestellte Bedienmenü auch, so daß die Einheitlichkeit der Anzeige und die Übersichtlichkeit für den Benutzer gewahrt bleiben.

Vorteilhaft ist weiterhin, daß durch Betätigung der Menütaste ein Bedienmenü auswählbar und zur Darstellung an der Anzeigevorrichtung bringbar ist und daß nach Betätigung des Bedienelementes und einer Auswahltaste die der Auswahltaste zugeordnete Bedienfunktion des gerade an der Anzeigevorrichtung dargestellten Bedienmenüs auf einem durch Betätigung einer beliebigen Auswahltaste adressierten Speicherplatz des durch das Bedienelement adressierten mindestens einen vorgegebenen Speicherbereichs abspeicherbar ist. Auf diese Weise läßt sich ein benutzerspezifisches Bedienmenü besonders einfach realisieren.

Bedienfunktionen eines Rundfunkempfängers vom Benutzer können nach dessen Vorstellungen und Wünschen in selbsterstellten Bedienmenüs zur Aktivierung angeordnet werden. Auf diese Weise wird der Bedienkomfort des Rundfunkempfängers für den Benutzer erhöht, da er die Bedienoberfläche nach seinen Bedürfnissen selbst gestalten kann. So kann er beispielsweise ein Bedienmenü erstellen, in dem häufig von ihm verwendete Bedienfunktionen aufgeführt sind.

Besonders vorteilhaft ist es, daß eine Folge von Bedienfunktionen vorzugsweise menügesteuert aufgerufen wird und daß die Folge von Bedienfunktionen auf den mindestens einen Speicherplatz abgespeichert wird. Auf diese Weise läßt sich durch Verkettung von Bedienfunktionen individuell eine neue Bedienfunktion erzeugen, so daß eine Reduzierung der Bedienschritte und damit eine Vereinfachung der Bedienung und eine Erhöhung des Bedienkomforts für den Benutzer ermöglicht wird.

Vorteilhaft ist außerdem, daß der Folge von Bedienfunktionen ein Funktionsname zugeordnet wird und daß der Funktionsname ebenfalls auf den zugehörigen Speicherplatz im mindestens einen vorgegebenen Speicherbereich abgespeichert wird. Auf diese Weise läßt sich die Folge von Bedienfunktionen für den Benutzer nach Aufruf des erstellten Bedienmenüs durch Anzeige des Funktionsnamens identifizieren und von anderen Bedienfunktionen unterscheiden.

Besonders vorteilhaft ist es, daß eine erneute Betätigung des Bedienelementes erfolgt, bevor die Speicherung der ausgewählten mindestens einen Bedienfunktion auf einem Speicherplatz stattfindet. Auf diese Weise läßt sich auch eine Folge von Bedienfunktionen auf einem einzigen Speicherplatz abspeichern, indem der Abschluß der Folge der Bedienfunktionen durch erneute Betätigung des Bedienelementes gekennzeichnet wird, so daß die anschließende Betätigung einer Auswahltaste als Adressierung eines Speicherplatzes für diese Folge von Bedienfunktionen interpretiert wird. Somit lassen sich mehrere Bedienvorgänge zur Realisierung einer Folge von Bedienfunktionen durch eine einzige Bedienfunktion zusammenfassen, so daß die Anzahl der Bedienvorgänge für den Benutzer erheblich reduziert werden kann und die Bedienung dadurch vereinfacht und komfortabler wird.

Vorteilhaft ist außerdem, daß eine Texteingabefunktion vorgesehen ist, mittels der der mindestens einen Bedienfunktion auf einem Speicherplatz ein Funktionsname zuordenbar ist und daß der Funktionsname auf dem Speicherplatz abspeicherbar ist. Dies ist vor allem für die Zusammenfassung einer Folge von Bedienfunktionen unter einer neuen Bedienfunktion von Bedeutung, da diese neue Bedienfunktion durch einen individuellen Funktionsnamen identifizierbar und von anderen Bedienfunktionen unterscheidbar wird.

Ein weiterer Vorteil besteht auch darin, daß ein Kartenleser in einem Kartenschacht vorgesehen ist, daß der mindestens eine vorgegebene Speicherbereich in einem entsprechend vorgegebenen Speicherbereich einer in den Kartenschacht eingeführten Chipkarte speicherbar ist und daß nach Einführen der Chipkarte in den Kartenschacht ein Ladevorgang erfolgt, bei dem der vorgegebene Speicherbereich der Chipkarte in den mindestens einen vorgegebenen Speicherbereich des Rundfunkempfängers kopiert wird. Auf diese Weise lassen sich an der Anzeigevorrichtung eines Rundfunkempfängers benutzerspezifische Bedienmenüs mehrerer Benutzer darstellen, ohne daß im Rundfunkempfänger entsprechende Speicherkapazität bereitgehalten werden muß, da die für den gerade aktuellen Benutzer vorgesehenen benutzerspezifischen Bedienmenüs von der Chipkarte in den Rundfunkempfänger geladen werden. Ein Rundfunkempfänger ist so für viele Benutzer individuell nutzbar. Die individuellen Bedienmenüs sind auf den benutzereigenen Chipkarten abgespeichert.

Vorteilhaft ist außerdem, daß der mindestens einevorgegebene Speicherbereich auf einer in den Kartenschacht eingeführten Chipkarte vorgesehen ist. Auf diese Weise kann der für die Speicherung der benutzerspezifischen Bedienmenüs im Rundfunkempfänger vorgesehene Speicherplatz eingespart werden.

### Zeichnung

Ein Ausführungsbeispiel der Erfindung ist in der Zeichnung dargestellt und in der nachfolgenden Beschreibung näher erläutert. Es zeigen Figur 1 eine Bedienfront eines erfindungsgemäßen Rundfunkempfängers, Figur 2 ein Blockschaltbild des erfindungsgemäßen Rundfunkempfängers und Figur 3 einen Ablaufplan zur Erläuterung der Funktionsweise des erfindungsgemäßen Rundfunkempfängers.

### Beschreibung des Ausführungsbeispiels

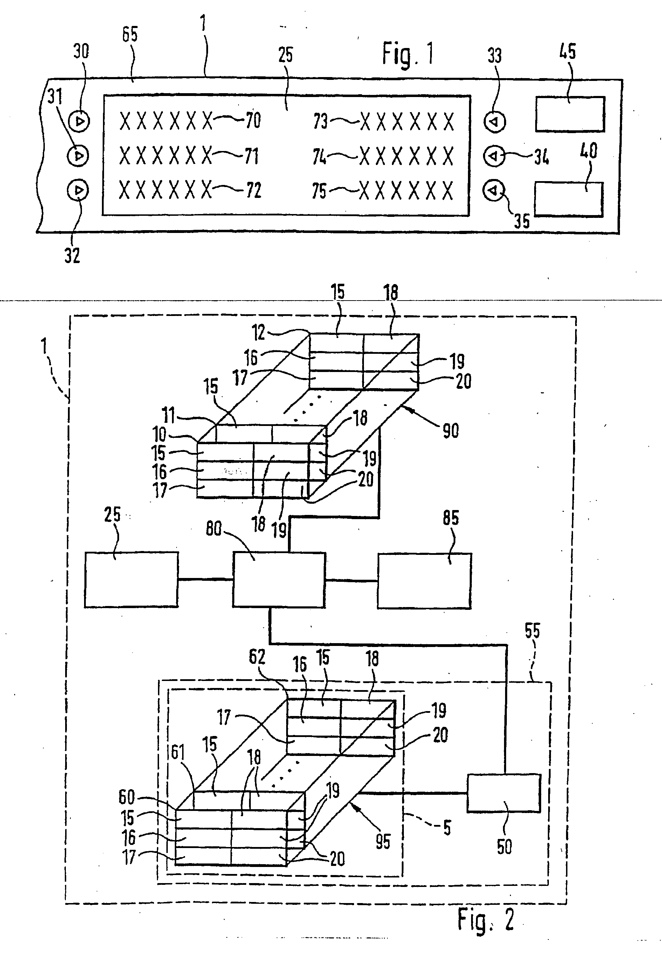

In Figur 1 ist eine Bedienfront 65 eines als Autoradio ausgebildeten Rundfunkempfängers 1 in einem für die Erfindung relevanten Teilbereich dargestellt. Dabei umfaßt die Bedienfront 65 eine Anzeigevorrichtung 25, die beispielsweise als Flüssigkristalldisplay ausgebildet sein kann. Die Anzeigevorrichtung 25 ist dabei rechteckförmig ausgebildet. In zwei Spalten zu je drei Zeilen sind an der Anzeigevorrichtung 25 sechs Bedienfunktionen 70, 71, 72, 73, 74, 75 graphisch darstellbar. Dabei ist in der linken Spalte eine erste Bedienfunktion 70, eine zweite Bedienfunktion 71 und eine dritte Bedienfunktion 72 und in der rechten Spalte eine vierte Bedienfunktion 73, eine fünfte Bedienfunktion 74 und eine sechste Bedienfunktion 75 darstellbar. Den Bedienfunktionen 70,..., 75 sind am linken und am rechten Rand der Anzeigevorrichtung 25 Auswahltasten 30,..., 35 räumlich und funktional zugeordnet. So ist der ersten Bedienfunktion 70 am linken Rand der Anzeigevorrichtung 25 eine erste Auswahltaste 30, der zweiten Bedienfunktion 71 am linken Rand der Anzeigevorrichtung 25 eine zweite Auswahltaste 31 und der dritten Bedienfunktion 72 am linken Rand der Anzeigevorrichtung 25 eine dritte Auswahltaste 32 zugeordnet. Der vierten Bedienfunktion 73 ist am rechten Rand der Anzeigevorrichtung 25 eine vierte Auswahltaste 33, der fünften Bedienfunktion 74 ist am rechten Rand der Anzeigevorrichtung 25 eine fünfte Auswahltaste 34 und der sechsten Bedienfunktion 75 ist am rechten Rand der Anzeigevorrichtung 25 eine sechste Auswahltaste 35 räumlich und funktional zugeordnet. Durch Betätigung einer der Auswahltasten 30,..., 35 wird die ihr zugeordnete und an der Anzeigevorrichtung 25 dargestellte Bedienfunktion 70,..., 75 aktiviert und ausgeführt. Die Bedienfront 65 umfaßt weiterhin eine Menütaste 45 und ein als Drehschalter ausgeführtes Bedienelement 40. Durch Betätigung der Menütaste 45 können sukzessive und in zyklischer Wiederholung voreingestellte und benutzerspezifische Bedienmenüs mit jeweils bis zu sechs Bedienfunktionen 70,..., 75 an der Anzeigevorrichtung 25 zur Darstellung gebracht werden. Dabei wird nach jeder Betätigung der Menütaste 45 auf das nächste Bedienmenü umgeschaltet. Durch Betätigung des Drehshalters 40 sind Speicherbereiche für benutzerspezifische Bedienmenüs adressierbar.

In Figur 2 ist ein Blockschaltbild des erfindungsgemäßen Rundfunkempfängers 1 dargestellt. Dabei sind nur die für die Erfindung relevante Elemente des Rundfunkempfängers 1 dargestellt. So umfaßt der Rundfunkempfänger 1 einen Schreib-Lese-Speicher 90, der mit einer Steuereinheit 80 verbunden ist. An die Steuereinheit 80 ist außerdem die Anzeigevorrichtung 25 und eine die Auswahltasten 30,..., 35, die Menütaste 45 und das Drehschalter 40 umfassende Tastatur 85 angeschlossen. Die Steuereinheit 80 ist außerdem mit einem in einem Kartenschacht 55 untergebrachten Kartenleser 50 verbunden, der mit den Kontakten eines Chips einer Chipkarte 5 im Kartenleser 55 kontaktiert, wodurch ein Schreib-Lese-Speicher 95 der Chipkarte 5 über den Kartenleser 50 mit der Steuereinheit 80 verbunden ist. Der Schreib-Lese-Speicher 90 des Rundfunkempfängers 1 umfaßt einen ersten vorgegebenen Speicherbereich 10, einen zweiten vorgegebenen Speicherbereich 11, einen dritten vorgegebenen Speicherbereich 12 und gegebenenfalls weitere vorgegebene Speicherbereiche, wie durch die Punktierung in Figur 2 angedeutet ist. Auch der Schreib-Lese-Speicher 95 der Chipkarte 5 umfaßt einen ersten vorgegebenen Speicherbereich 60, einen zweiten vorgegebenen Speicherbereich 61, einen dritten vorgegebenen Speicherbereich 62 und gegebenenfalls weitere vorgegebene Speicherbereiche wie in Figur 2 ebenfalls durch Punktierung angedeutet ist. Dabei entspricht die Anzahl der im Schreib-Lese-Speicher 95 der Chipkarte 5 vorgegebenen Speicherbereiche 60, 61, 62 vorteilhafterweise der Anzahl der im Schreib-Lese-Speicher 90 des Rundfunkempfängers 1 vorgegebenen Speicherbereiche 10, 11, 12. Die vorgegebenen Speicherbereiche 10, 11, 12 des Schreib-Lese-Speichers 90 des Rundfunkempfängers 1 und die vorgegebenen Speicherbereiche 60, 61, 62 des Schreib-Lese-Speichers 95 der Chipkarte 5 sind jeweils in sechs Speicherplätze 15,..., 20 unterteilt. In jedem Speicherplatz 15,..., 20 ist eine Bedienfunktion des Rundfunkempfängers 1 abspeicherbar. In jedem der vorgegebenen Speicherbereiche 10, 11, 12, 60, 61, 62 ist jeweils ein vollständiges Bedienmenü abspeicherbar, wie es an der Anzeigevorrichtung 25 zur Darstellung gebracht werden kann. Dabei wird für jeden Speicherbereich 10. 11, 12, 60, 61, 62 ein erster Speicherplatz 15 für die erste Bedienfunktion 70 des entsprechenden Bedienmenüs, ein zweiter Speicherplatz 16 für die zweite Bedienfunktion 71 des entsprechenden Bedienmenüs, ein dritter Speicherplatz 17 für die dritte Bedienfunktion 72 des entsprechenden Bedienmenüs, ein vierter Speicherplatz 18 für die vierte Bedienfuriktion 73 des entsprechenden Bedienmenüs, ein fünfter Speicherplatz 19 fürdie fünfte Bedienfunktion 74 des entsprechenden Bedienmenüs und ein sechster Speicherplatz 20 für die sechste Bedienfunktion 75 des entsprechenden Bedienmenüs vorgesehen, wobei in den vorgegebenen Speicherbereichen 10, 11, 12, 60, 61, 62 nur benutzerspezifische und vom Benutzer erstellte Bedienmenüs abgespeichert werden können. Die Speicherung wird dabei von der Steuereinheit 80 in Abhängigkeit von Eingaben an der Tastatur 85 gesteuert. Die Steuereinheit 80 steuert auch die Anzeige des jeweils über die Tastatur 85 eingestellten bzw. ausgewählten Bedienmenüs an der Anzeigevorrichtung 25.

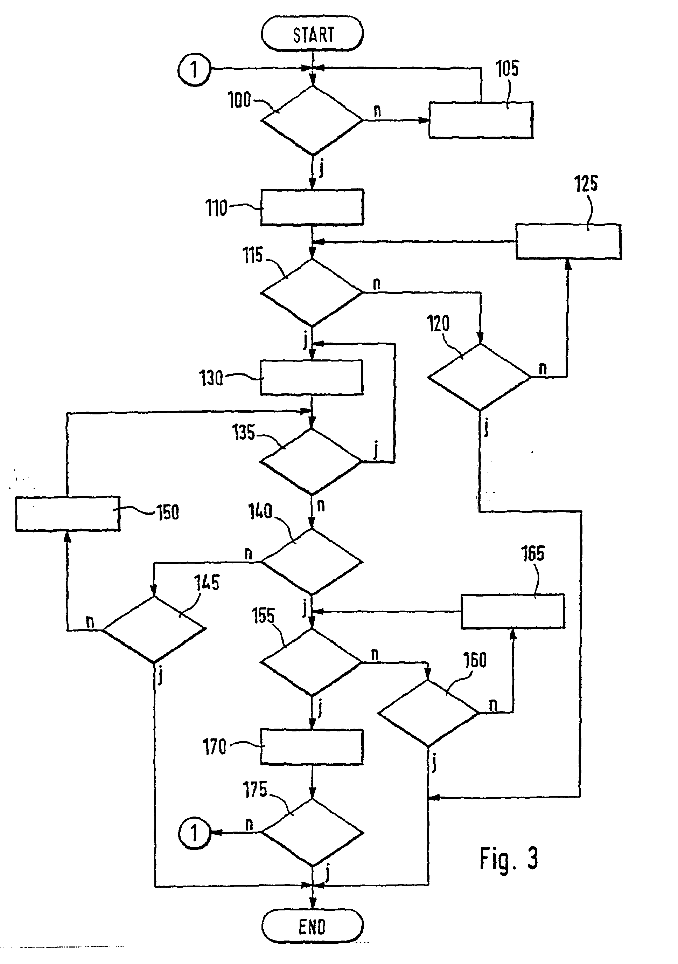

Die Funktionsweise des Blockschaltbildes gemäß Figur 2 wird nun anhand des Ablaufplans gemäß Figur 3 erläutert. Nachdem der Rundfunkempfänger 1 eingeschaltet wurde, kann durch Betätigung der Menütaste 45 zwischen den voreingestellten und den benutzerspezifischen Bedienmenüs sowie ihrer Darstellung an der Anzeigevorrichtung 25 umgeschaltet werden. Bei mehreren vorgegebenen Speicherbereichen 10, 11, 12 im Rundfunkempfänger 1 empfiehlt sich die Verwendung eines mehrstufigen Bedienelementes 40, eines Drehschalters, der gleichzeitig als Druckschalter realisiert ist. Die einzelnen vorgegebenen Speicherbereiche können so durch unterschiedliche Stellungen des Drehschalters 40 adressiert werden, wobei durch Drücken des Drehschalters 40 dann der Speichervorgang eingeleitet wird. Bei Ausbildung des Bedienelementes 40 als Drehschalter kann auch eine Position des Drehschalters für die Einleitung des Speichervorgangs vorgesehen sein, so daß keine zusätzliche Druckschaltung des Bedienelementes 40 erforderlich ist.

Nach Betätigung der Menütaste 45 zur Darstellung eines Bedienmenüs an der Anzeigevorrichtung 25 startet in der Steuereinheit 80 ein Programm, das bei einem Programmpunkt 100 prüft, ob durch Betätigung des Drehschalters 40 ein vorgegebener Speicherbereich 10, 11, 12 adressiert wurde. Ist dies der Fall, so wird zu Programmpunkt 110 verzweigt, andernfalls wird zu Programmpunkt 105 verzweigt. Bei Programmpunkt 105 wird eine Warteschleife durchlaufen und anschließend wird wieder zu Programmpunkt 100 zurückverzweigt. Bei Programmpunkt 110 wird der vom Drehschalter 40 ausgewählte vorgegebene Speicherbereich 10, 11, 12 durch die Steuereinheit 80 adressiert. Bei Programmpunkt 115 prüft die Steuereinheit 80, ob eine der Auswahltasten 30,..., 35 gedrückt wurde. Ist dies der Fall, so wird zu Programmpunkt 130 verzweigt, andernfalls wird zu Programmpunkt 120 verzweigt. Bei Programmpunkt 120 prüft die Steuereinheit 80, ob der Speichervorgang abgebrochen wurde, wozu beispielsweise bei einem Drehschalter 40 eine weitere Schalterstellung vorgesehen sein kann. Weiterhin ist auch denkbar, eine zusätzliche Taste zum Abbruch eines Speichervorgangs an der Bedienfront 65 vorzusehen. Stellt die Steuereinheit 80 bei Programmpunkt 120 fest, daß der Speichervorgang abgebrochen werden soll, so wird das Programm beendet, andernfalls wird zu einem Programmpunkt 125 verzweigt, bei dem eine Warteschleife durchlaufen wird. Nach Durchlaufen der Warteschleife, wird wieder zu Programmpunkt 115 zurückverzweigt. Bei Programmpunkt 130 wird die der gedrückten Auswahltaste 30,..., 35 an der Anzeigevorrichtung 25 zugeordnete Bedienfunktion 70,..., 75 ausgewählt. Bei Programmpunkt 135 wird geprüft, ob erneut eine Auswahltaste 30,..., 35 betätigt wurde. Ist dies der Fall, so wird zu Programmpunkt 130 zurückverzweigt und die ausgewählte Bedienfunktion 70,..., 75 an bereits zuvor ausgewählte Bedienfunktionen 70,..., 75 angehängt, so daß eine Folge von Bedienfunktionen 70,..., 75 entsteht. Dabei können auch Bedienfunktionen 70,..., 75 von verschiedenen Bedienmenüs durch entsprechende Betätigung der Menütaste 45 für die Bildung einer solchen Folge von Bedienfunktionen 70,..., 75 herangezogen werden. Wird bei Programmpunkt 135 keine erneute Betätigung einer Auswahltaste 30,..., 35 von der Steuereinheit 80 erkannt, so wird zu Programmpunkt 140 verzweigt. Bei Programmpunkt 140 wird geprüft, ob mittels dem Drehschalters 40 der Speichervorgang eingeleitet wurde. Ist dies der Fall, so wird zu Programmpunkt 155 verzweigt, andernfalls wird zu Programmpunkt 145 verzweigt. Bei Programmpunkt 145 wird geprüft, ob der Speichervorgang in der bereits beschriebenen Weise beendet wurde. Ist dies der Fall, so wird das Programm beendet, andernfalls wird zu Programmpunkt 150 verzweigt. Bei Programmpunkt 150 wird eine Warteschleife durchlaufen und anschließend wird zu Programmpunkt 135 zurückverzweigt. Bei Programmpunkt 155 wird geprüft, ob eine Auswahltaste 30,..., 35 betätigt wurde. Ist dies der Fall, so wird zu Programmpunkt 170 verzweigt, andernfalls wird zu Programmpunkt 160 verzweigt. Bei Programmpunkt 160 wird geprüft, ob der Speichervorgang in der bereits beschriebenen Weise beendet werden soll. Ist dies der Fall, so wird das Programm verlassen, andernfalls wird zu Programmpunkt 165 verzweigt. Bei Programmpunkt 165 wird eine Warteschleife durchlaufen und anschließend wieder zu Programmpunkt 155 zurückverzweigt. Bei Programmpunkt 170 wird die ausgewählte Bedienfunktion 70,..., 75 bzw. die Folge von ausgewählten Bedienfunktionen 70,..., 75 in dem durch die zuletzt erfolgte Betätigung einer Auswahltaste 30,..., 35 adressierten Speicherplatz 15,..., 20 des ausgewählten vorgegebenen Speicherbereichs 10,11,12 des Rundfunkempfängers 1 abgespeichert. Bei Programmpunkt 175 wird geprüft, ob der Speichervorgang in der beschriebenen Weise beendet wurde. Ist dies der Fall, so wird das Programm verlassen, andernfalls wird zu Programmpunkt 100 zurückverzweigt.

Wird durch Betätigung des Drehschalters 40 nach bereits erfolgter Auswahl mindestens einer abzuspeichemden Bedienfunktion 70,..., 75 und vor Einleitung des Speichervorgangs ein anderer vorgegebener Speicherbereich 10, 11, 12 ausgewählt, so bleibt diese Auswahl wirkungslos und wird als Einleitung des Speichervorgangs interpretiert. Auf eine spezielle Betätigungsdauer bzw. Drehstellung des Drehschalters 40 zur Einleitung des Speichervorgangs kann daher auch verzichtet werden. Eine Änderung der Auswahl des vorgegebenen Speicherbereichs 10, 11, 12 vor Auswahl der ersten Bedienfunktion 70,..., 75 durch Betätigung des Drehschalters 40 hingegen ist möglich.

Nach Beendigung des Speichervorgangs und vor Entnahme der Chipkarte 5 aus dem Kartenschacht 5 55 veranlaßt die Steuereinheit 80 das Überschreiben des Schreib-Lese-Speichers 95 der Chipkarte 5 durch den Inhalt des Schreib-Lese-Speichers 90 des Rundfunkempfängers 1. Auf diese Weise werden die benutzerspezifischen Bedienmenüs auf der Chipkarte 5 gespeichert.

Beim Einführen der Chipkarte 5 in den Kartenleser 55 wird von der Steuereinheit 80 nach Detektion der Kontaktierung des Schreib-Lese-Speichers 95 der Chipkarte 5 mit dem Kartenleser 50 ein Ladevorgang gestartet, der den Inhalt des Schreib-Lese-Speichers 95 der Chipkarte 5 in den Schreib-Lese-Speicher 90 des Rundfunkempfängers 1 kopiert. Auf diese Weise enthält der Schreib-Lese-Speicher 90 jeweils die benutzerspezifischen Bedienmenüs des Besitzers der Chipkarte 5. Zur Darstellung an der Anzeigevorrichtung 25 kann die Steuereinheit 80 die benutzerspezifischen Bedienmenüs dann aus dem Schreib-Lese-Speicher 90 des Rundfunkempfängers 1 abrufen.

Über den Kartenleser 50 können dazu sowohl Daten vom Schreib-Lese-Speicher 95 der Chipkarte 5 gelesen als auch Daten auf den Schreib-Lese-Speicher 95 der Chipkarte 5 geschrieben werden.

Um Speicherplatz im Rundfunkempfänger 1 einzusparen, kann auf den Schreib-Lese-Speicher 90 des Rundfunkempfängers 1 auch verzichtet werden, wobei dann die Steuereinheit 80 die benutzerspezifischen Bedienmenüs direkt auf dem Schreib-Lese-Speicher 95 der in den Kartenschacht 55 eingeführten Chipkarte 5 abspeichert bzw. zur Darstellung der benutzerspezifischen Bedienmenüs an der Anzeigevorrichtung 25 und zur Aktivierung der dort vorgesehenen Bedienfunktionen 70,..., 75 diese benutzerspezifischen Bedienmenüs direkt aus dem Schreib-Lese-Speicher95 der Chipkarte 5 abruft.

Da die Bedienfunktionen 70,..., 75 rein softwaremäßig implementiert sein müssen, um in den vorgegebenen Speicherbereichen 10, 11, 12, 60, 61, 62 abgespeichert werden zu können, können die benutzerspezifischen Bedienmenüs auch von einer externen Datenverarbeitungseinrichtung, beispielsweise einem Computer, mit entsprechendem Kartenschacht und Kartenleser sowie der implementierten Software im Schreib-Lese-Speicher 95 der in diesen Kartenschacht eingeführten Chipkarte 5 abgespeichert werden.

Die vom Benutzer in den Speicherplätzen 15,..., 20 abgespeicherten Bedienfunktionen 70,..., 75 oder Folgen von Bedienfunktionen 70,..., 75 können vom Benutzer durch jeweils einen eigens gewählten Funktionsnamen gekennzeichnet werden, der ebenfalls auf den zugehörigen Speicherplatz 15,..., 20 abgespeichert wird. Für die Eingabe dieses Funktionsnamens kann im Rundfunkempfänger 1 bzw. in der Datenverarbeitungseinrichtung eine Texteingabefunktion vorgesehen sein, mittels der der Benutzer einen alphanumerischen Funktionsnamen eingeben kann. Die Texteingabe erfolgt dabei sinnvollerweise direkt im Anschluß an Programmpunkt 140 gemäß Figur 3, wobei die Texteingabefunktion in dem Fachmann beispielsweise durch die Benamung von Compact-Discs an entsprechenden Audiogeräten bekannter Weise realisiert ist. Zusammen mit der Bedienfunktion 70,..., 75 bzw. der Folge von Bedienfunktionen 70,..., 75 wird der Funktionsname dann auf dem entsprechenden Speicherplatz 15,..., 20 abgespeichert und erscheint nach Aufruf des entsprechenden benutzerspezifischen Bedienmenüs an entsprechender Stelle an der Anzeigevorrichtung 25.

Sowohl fest voreingestellte Bedienmenüs des Rundfunkempfängers 1 als auch die benutzerspezifischen Bedienmenüs sind durch Betätigung der Menütaste 45 auswählbar und zur Darstellung an der Anzeigevorrichtung 25 bringbar. Durch Betätigung einer Auswahltaste 30,..., 35 wird dann die ihr zugeordnete und an der Anzeigevorrichtung 25 dargestellte Bedienfunktion 70,..., 75 aktiviert.

Die Auswahl der Bedienfunktionen 70,..., 75 zur Abspeicherung in den benutzerspezifischen Bedienmenüs muß nicht unbedingt menügesteuert erfolgen. So kann nach Betätigung des Drehchalters 40, die eine Aktivierung einer anschließend gewählten Bedienfunktion 70,..., 75 verhindert und deren Speicherung in einem benutzerspezifischen Bedienmenü vorbereitet, eine Bedienfunktion 70,..., 75 auch durch Betätigung einer ihr permanent zugewiesenen Taste an der Bedienfront 65 des Rundfunkempfängers 1 ausgewählt werden.

Soll auf die Speicherung von benutzerspezifischen Bedienmenüs auf der Chipkarte 5 verzichtet werden, so kann der Schreib-Lese-Speicher 90 des Rundfunkempfängers 1 gegebenenfalls mit einer größeren Anzahl von vorgegebenen Speicherbereichen 10, 11, 12 versehen werden, um für mehrere Benutzer die Erstellung und Speicherung benutzerspezifischer Bedienmenüs zu ermöglichen.

Für die Erstellung benutzerspezifischer Bedienmenüs können sowohl Bedienfunktionen 70,..., 75 von im Rundfunkempfänger 1 voreingestellten Bedienmenüs als auch Bedienfunktionen 70,..., 75 von bereits erstellten und abgespeicherten benutzerspezifischen Bedienmenüs verwendet werden.

## Patentansprüche

1. Rundfunkempfänger (1), insbesondere Autoradio, mit einer Anzeigevorrichtung (25) und insbesondere seitlich an der Anzeigevorrichtung (25) angebrachten Auswahltasten (30,..., 35), die einzelnen, vorzugsweise an der Anzeigevorrichtung (25) darstellbaren Bedienfunktionen (70, ..., 75) zugeordnet sind, **dadurch gekennzeichnet, daß** ein Drehschalter (40) vorgesehen ist, mittels dem mindestens ein vorgegebener Speicherbereich (10, 11, 12) adressierbar ist, daß durch die Auswahltasten (30, ..., 35) Speicherplätze (15,..., 20) in dem mindestens einen vorgegebenen Speicherbereich (10, 11, 12) adressierbar sind und daß mindestens eine auf der Anzeigevorrichtung (25) dargestellte Bedienfunktion (70,..., 75) des Rundfunkempfängers (1) durch gleichzeitige oder aufeinanderfolgende Betätigung einerseits des Drehschalters (40) und andererseits einer beliebigen Auswahltaste (30, ..., 35) auf dem durch die beliebige Auswahltaste (30, ..., 35) adressierten Speicherplatz (15, ..., 20) des mindestens einen vorgegebenen Speicherbereichs (10, 11, 12) abspeicherbar ist.

2. Rundfunkempfänger (1) nach Anspruch 1, **dadurch gekennzeichnet, daß** eine Menütaste (45) vorgesehen ist, durch deren Betätigung der Inhalt des mindestens einen vorgegebenen Speicherbereiches (10, 11, 12) an der Anzeigevorrichtung (25) darstellbar ist, wobei jeder Auswahltaste (30, ..., 35) die Bedienfunktion (70, ..., 75) zugeordnet ist, die auf dem durch diese Auswahltaste (30, ..., 35) adressierten Speicherplatz (15, ..., 20) gespeichert ist, und wobei durch Betätigung einer Auswahltaste (30, .. , 35) die ihr zugeordnete Bedienfunktion (70, ..., 75) aktiviert wird.

3. Rundfunkempfänger (1) nach Anspruch 1 oder 2, **dadurch gekennzeichnet, daß** durch Betätigung der Menütaste (45) ein Bedienmenü auswählbar und zur Darstellung an der Anzeigevorrichtung (25) bringbar ist.

4. Rundfunkempfänger (1) nach einem der Ansprüche 1-3, **dadurch gekennzeichnet, daß** nach Betägigung des Bedienelementes (40) und der nachfolgenden Betätigung wenigstens einer Auswahltaste (30, ..., 35) die der Auswahltaste (30, ..., 35) zugeordnete Bedienfunktion (70, ..., 75) des gerade an der Anzeigevorrichtung (25) dargestellten Bedienmenüs auf einem durch Betätigung einer beliebigen Auswahltaste (30, ..., 35) adressierten Speicherplatz (15, ..., 20) des durch das Bedienelement (40) adressierten mindestens einen vorgegebenen Speicherbereichs (10, 11, 12) abspeicherbar ist.

5. Rundfunkempfänger (1) nach einem der Anspruch 1-4, 7, **dadurch gekennzeichnet, daß** eine erneute Betätigung des Bedienelementes (40) erfolgt, bevor die Speicherung der ausgewählten mindestens einen Bedienfunktion (70, ..., 75) auf einem Speicherplatz (15, ..., 20) stattfindet.

6. Rundfunkempfänger (1) nach einem der Ansprüche 1-5 **dadurch gekennzeichnet, daß** eine Texteingabefunktion vorgesehen ist, mittels der der mindestens einen Bedienfunktion (70, ..., 75) auf einem Speicherplatz (15, ..., 20) ein Funktionsname zuordenbar ist und daß der Funktionsname auf dem Speicherplatz (15, ..., 20) abspeicherbar ist.

7. Rundfunkempfänger (1) nach einem der Ansprüche 1-6 **dadurch gekennzeichnet, daß** ein Kartenleser (50) in einem Kartenschacht (55) vorgesehen ist und daß der mindestens eine vorgegebene Speicherbereich (10, 11, 12) in einem entsprechend vorgegebenen Speicherbereich (60, 61, 62) einer in den Kartenschacht (55) eingeführten Chipkarte (5) speicherbar ist.

8. Rundfunkempfänger (1) nach Anspruch 7, **dadurch gekennzeichnet, daß** nach Einführen der Chipkarte (5) in den Kartenschacht (55) ein Ladevorgang erfolgt, bei dem der vorgegebene Speicherbereich (60, 61, 62) der Chipkarte (5) in den mindestens einen vorgegebenen Speicherbereich (10, 11, 12) des Rundfunkempfängers (1) kopiert wird.

9. Rundfunkempfänger (1) nach einem der Ansprüche 1-8 **dadurch gekennzeichnet, daß** ein Kartenleser (50) in einem Kartenschacht (55) vorgesehen ist und daß der mindestens eine vorgegebene Speicherbereich (10, 11, 12) auf einer in den Kartenschacht (55) eingeführten Chipkarte (5) vorgesehen ist.

## Claims

1. Broadcast radio receiver (1), in particular a car radio, having a display apparatus (25) and, in particular, selection keys (30, ..., 35) which are fitted at the side on the display apparatus (25) and are associated with the individual control functions (70, ..., 75), which can preferably be displayed on the display apparatus (25), **characterized in that** one rotary switch (40) is provided by means of which at least one predetermined memory area (10, 11, 12) can be addressed, **in that** the selection keys (30, ..., 35) can be used to address memory locations (15, ..., 20) in the at least one predetermined memory area (10, 11, 12), and **in that** at least one control function (70, ..., 75) which is displayed on the display apparatus (25), of the broadcast radio receiver (1) can be stored by simultaneous or successive operation firstly of the rotary switch (40) and secondly of any desired selection key (30, ..., 35) at the memory location (15, ..., 20) which is addressed by that particular selection key (30, ..., 35) in the at least one predetermined memory area (10, 11, 12).

2. Broadcast radio receiver (1) according to Claim 1, **characterized in that** a menu key (45) is provided, whose operation allows the contents of the at least one predetermined memory area (10, 11, 12) to be displayed on the display apparatus (25), with each selection key (30, ..., 35) having an associated control function (70, ..., 75) which is stored in the memory location (15, ..., 20) addressed by this selection key (30, ..., 35), and with operation of a selection key (30, ..., 35) activating the control function (70, ..., 75) associated with it.

3. Broadcast radio receiver (1) according to Claim 1 or 2, **characterized in that** operation of the menu key (45) allows a control menu to be selected and to be displayed on the display apparatus (25).

4. Broadcast radio receiver (1) according to one of Claims 1-3, **characterized in that**, after operation of the control element (40) and after subsequent operation of at least one selection key (30, ..., 35), the control function (70, ..., 75) which is associated with that selection key (30, ..., 35) in the control menu currently being displayed on the display apparatus (25) can be stored in a memory location (15, ..., 20), which is addressed by operating any given selection key (30, ..., 35), in the at least one predetermined memory area (10, 11, 12) which is addressed by the control element (40).

5. Broadcast radio receiver (1) according to one of Claims 1-4, **characterized in that** the control element (40) is operated once again before the selected at least one control function (70, ..., 75) is stored in a memory location (15, ..., 20).

6. Broadcast radio receiver (1) according to one of Claims 1-5, **characterized in that** a text input function is provided, by means of which the at least one control function (70, ..., 75) can be assigned a function name in a memory location (15, ..., 20) and **in that** the function name can be stored **in that** memory location (15, ..., 20).

7. Broadcast radio receiver (1) according to one of Claims 1-6, **characterized in that** a card reader (50) is provided in a card slot (55), and **in that** the at least one predetermined memory area (10, 11, 12) can be stored in a correspondingly predetermined memory area (60, 61, 62) in a smart card (5) which is inserted into the card slot (55).

8. Broadcast radio receiver (1) according to Claim 7, **characterized in that**, once the smart card (5) has been inserted into the card slot (55), a loading process takes place, in which the predetermined memory area (60, 61, 62) in the smart card (5) is copied into the at least one predetermined memory area (10, 11, 12) in the broadcast radio receiver (1).

9. Broadcast radio receiver (1) according to one of Claims 1-8, **characterized in that** a card reader (50) is provided in a card slot (55), and **in that** the at least one predetermined memory area (10, 11, 12) is provided in a smart card (5) which has been inserted into the card slot (55).

## Revendications

1. Récepteur radiophonique (1) notamment autoradio comportant un dispositif d'affichage (25) et notamment à côté du dispositif d'affichage (25), des touches de sélection (30 ... 35) associées à différentes fonctions de service (70 ... 75) affichables de préférence sur le dispositif d'affichage (25),
**caractérisé en ce que**
un commutateur tournant (40) adresse au moins une zone de mémoire prédéterminée (10, 11, 12) et, par les touches de sélection (30 ... 35), on adresse des emplacements de mémoire (15 ... 20) dans au moins une zone de mémoire prédéterminée (10, 11, 12), et on mémorise au moins une fonction de service (70 ... 75) du récepteur radiophonique (1) affichée par le dispositif d'affichage (25), par l'actionnement simultané ou successif d'une part du commutateur tournant (40) et d'autre part d'une touche de sélection (30 ... 35) quelconque à l'emplacement de mémoire (15 ... 20) d'au moins une zone de mémoire prédéterminée (10, 11, 12), cet emplacement étant adressé par une touche de sélection (30 ... 35) quelconque.

2. Récepteur radiophonique (1) selon la revendication 1,
**caractérisé par**
une touche de menu (45) dont l'actionnement affiche le contenu d'au moins un emplacement de mémoire prédéterminé (10, 11, 12) sur le dispositif d'affichage (25), en associant à chaque touche de sélection (30...35) la fonction de service (70 ... 75) mémorisée à l'emplacement de mémoire (15 ... 20) adressé par cette touche de sélection (30 ... 35) et en activant par l'actionnement d'une touche de sélection (30 ... 35), la fonction de service (70 ... 75) qui lui est associée.

3. Récepteur radiophonique (1) selon l'une des revendications 1 ou 2,
**caractérisé en ce que**
par l'actionnement de la touche de menu (45), on sélectionne un menu de service et on l'affiche sur le dispositif d'affichage (25).

4. Récepteur radiophonique (1) selon l'une des revendications 1 à 3 ou 6,
**caractérisé en ce qu'**
après l'actionnement du commutateur tournant (40) et l'actionnement suivant d'au moins une touche de sélection (30 ... 35), on mémorise la fonction de service (70 ... 75) du menu de service précisément affiché sur le dispositif d'affichage (25) correspondant à la touche de sélection (30 ... 35), dans un emplacement de mémoire (15 ... 20) adressé par l'actionnement d'une touche de sélection quelconque (30 ... 35), cet emplacement correspondant à au moins une zone de mémoire prédéterminée (10, 11, 12) adressé par le commutateur tournant (40).

5. Récepteur radiophonique (1) selon l'une quelconque des revendications 1 à 4,
**caractérisé en ce qu'**
un nouvel actionnement du commutateur tournant (40) se produit avant la mémorisation d'au moins une fonction de service sélectionnée (70 ... 75) à un emplacement de mémoire (15 ... 20).

6. Récepteur radiophonique (1) selon l'une quelconque des revendications 1 à 5,
**caractérisé en ce qu'**
une fonction d'entrée de texte permet d'associer un nom de fonction à au moins une fonction de service (70 ... 75) à un emplacement de mémoire (15 ... 20), et le nom de fonction est mémorisé à l'emplacement de mémoire (15 ... 20).

7. Récepteur radiophonique (1) selon l'une quelconque des revendications 1 à 6,
**caractérisé en ce qu'**
un lecteur de carte (50) est prévu dans un compartiment à carte (55) et au moins une zone de mémoire prédéterminée (10, 11, 12) est mémorisée dans une zone de mémoire prédéterminée correspondante (60, 61, 62) d'une carte à puce (5) introduite dans le compartiment à carte (55).

8. Récepteur radiophonique (1) selon la revendication 7,
**caractérisé en ce qu'**
après introduction de la carte à puce (5) dans le compartiment à carte (55), il y a une opération de chargement par laquelle la zone de mémoire prédéterminée (60, 61, 62) de la carte à puce (5) est copiée dans au moins une zone de mémoire (10, 11, 12) prédéterminée du récepteur radiophonique (1).

9. Récepteur radiophonique (1) selon l'une quelconque des revendications 1 à 8,
**caractérisé en ce qu'**
un lecteur de carte (50) est prévu dans un compartiment à carte (55) et au moins une zone de mémoire prédéterminée (10, 11, 12) est prévue sur une carte à puce (5) introduite dans le compartiment à carte (55).
